# EUROPEAN PATENT APPLICATION

(11) **EP 2 538 542 A1**
(43) Date of publication of application: **26.12.2012**
(21) Application number: 11180319.3
(22) Date of filing: 07.09.2011
(51) Int. Cl.: H02M 7/00, H05K 7/14

(54) **Frequency converter in which main devices are modularly mounted**

(30) Priority: 20.06.2011 CN 201110165624
(71) Applicant: Shenzhen Invt Electric Co., Ltd., Nanshan District Shenzhen 518055 (CN)
(72) Inventor: Su, Huijie, 518055 Shenzhen (CN)
(74) Representative: Kling, Simone

(57) **Abstract**

The present invention discloses a frequency converter in which the main devices are modularly mounted, including a housing and three main device units, wherein a support frame is provided inside the housing; three main device units are supported on the support frame side by side. Each of the main device units includes a mounting frame on which a rectifier bridge, an inverter module and a plurality of capacitors are arranged. The rectifier bridge, the inverter module and the capacitors of the frequency converter are separately arranged on three mounting frames to form three main device units, such that the ratio of the length to the width of each of the main device units is relative coordinate, and each of the main device units may be cooperated and arranged with other auxiliary devices inside the housing compactly. Therefore, the space utilization rate inside the housing is enhanced, the total volume of the frequency converter is reduced and the space cost is effectively cut down. Furthermore, each of the main device units is an interchangeable modular unit. Therefore, by adopting modularly mounting method, the complexity of the mounting process is reduced and the working efficiency of mounting is improved.

## Description

The present application claims the benefit of priority to Chinese patent application No. 201110165624.5 titled "FREQUENCY CONVERTER IN WHICH THE MAIN DEVICES ARE MODULARLY MOUNTED", filed with the Chinese State Intellectual Property Office on June 20, 2011. The entire disclosure thereof is incorporated herein by reference.

### FIELD OF THE INVENTION

The present application relates to a frequency converter, especially to a frequency converter in which the main devices are modularly mounted.

### BACKGROUND OF THE INVENTION

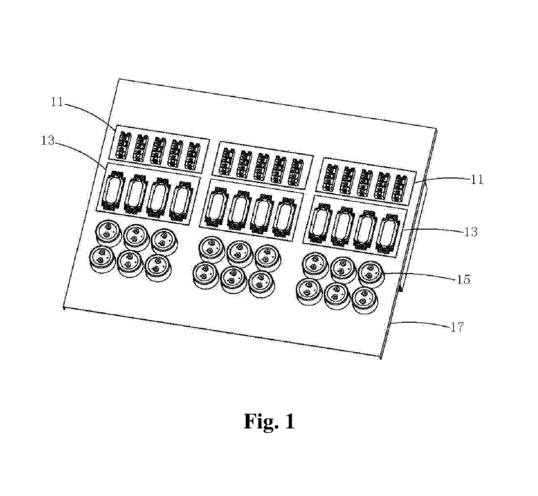

The mounting structure of the main devices (including the rectifier bridge, the inverter module and the capacitor) of the frequency converter of the prior art is shown in Figure 1. Three rectifier bridges 11, three inverter modules 13 and several capacitors 15 of the frequency converter are fixed on the same mounting plate 17, wherein three rectifier bridges 11 and three inverter modules 13 are arranged in line, respectively. When adopting such design manner, the mounting plate 17 having relative large area is required to satisfy the mounting requirements of the main devices. Furthermore, auxiliary devices such as a radiator, cooling fan and so on are also arranged in the housing of the frequency converter. In this way, due to uncoordinated scale between the dimensions (including length, width and height) of mounting plate 17 and auxiliary devices such as radiator, the main devices and the auxiliary devices could not be compactly arranged in the housing and the space utilization rate in the housing is very low. Therefore, only the housing having large volume is able to satisfy the mounting requirements, the frequency converter has to be bulky and occupy a large space.

### SUMMARY OF THE INVENTION

The object of the present invention is to solve the technical problems existed in known frequency converter, such as low internal space utilization rate and large volume of the housing, and provide a frequency converter in which the main devices are modularly mounted, which has high internal space utilization rate and small total volume of the housing.

In order to solve the above technical problems, following technical solution are adopted in the present invention: a frequency converter in which the main devices are modularly mounted, including a housing and three main device units, wherein a support frame is arranged inside the housing; the three main devices are supported on the support frame side by side, and each of the main device units includes a mounting frame on which a rectifier bridge, an inverter module and a plurality of capacitors are arranged.

In the above-mentioned frequency converter, each of the main device units is provided with the rectifier bridge, the inverter module and the capacitors, which belong to the same phase, of the frequency converter.

In the above-mentioned frequency converter, a connecting terminal of the main device unit which is used to electrically connect with an external device is provided at a front side of the mounting frame.

In the above-mentioned frequency converter, the same number of capacitors are provided on each of the main device units.

In the above-mentioned frequency converter, a pair of lower guide rails is formed at both sides of a lower end of the mounting frame, a pair of lower guide grooves is formed on the support frame at positions which correspond to that of the lower guide rails so as to match with the lower guide rails, and the lower guide rails are positioned into the lower guide grooves.

In the above-mentioned frequency converter, a pair of upper guide rails is formed at both sides of an upper end of the mounting frame, a pair of upper guide grooves is formed inside the housing at positions which correspond to that of the upper guide rails so as to match with the upper guide rails, and the upper guide rails are positioned into the upper guide grooves.

In the above-mentioned frequency converter, the rectifier bridge, the inverter module and the capacitors are provided at an upper portion, a middle portion and a lower portion of the mounting frame, respectively.

In the above-mentioned frequency converter, an upper fixing plate on which a hole is formed is provided on an upper end of a front side of the mounting frame.

In the above-mentioned frequency converter, a lower fixing plate on which a hole is formed is provided on a lower end of a front side of the mounting frame.

In the above-mentioned frequency converter, the housing is of a rectangular parallelepiped structure in which at least one cooling fan is provided, an upper vent is formed at an upper portion of a side wall of the housing, and a lower vent is formed at a lower portion of the side wall of the housing.

The advantageous effects of the present invention lie in that: the rectifier bridge, the inverter module and the capacitors of the frequency converter are separately provided on three mounting frames to form three main device units, such that the ratio of the length to the width of each of the main device units is relative coordinate, and each of the main device units may be cooperated with the other auxiliary devices provided in the housing and arranged in the housing compactly. Therefore, the space utilization rate inside the housing is improved, total volume of the frequency converter is reduced and space cost is effectively cut down; furthermore, each of the main device units includes a rectifier bridge, a inverter module and a plurality of capacitors and each of the main device units is an interchangeable modular unit, therefore, by adopting modularly mounting method, the complexity of the mounting process is reduced and the working efficiency of mounting is enhanced.

### BRIEF DESCRIPTION OF THE DRAWINGS

Figure 1 is a schematic view showing the mounting structure of the main devices of the frequency converter of the prior art;

Figure 2 is a perspective structural schematic view according to the present invention;

Figure 3 is a structural schematic view of the main device unit according to the present invention;

Figure 4 is a block schematic diagram showing the arrangement of the main devices according to the present invention;

Figure 5 is a schematic view showing the main device unit according to the present invention when it is mounted on the housing.

### DETAILED DESCRIPTION

In order to aid those skilled in the art in better understanding the object, technical solution and advantage of the present invention, the present invention will be further described with reference to the attached drawings and embodiments.

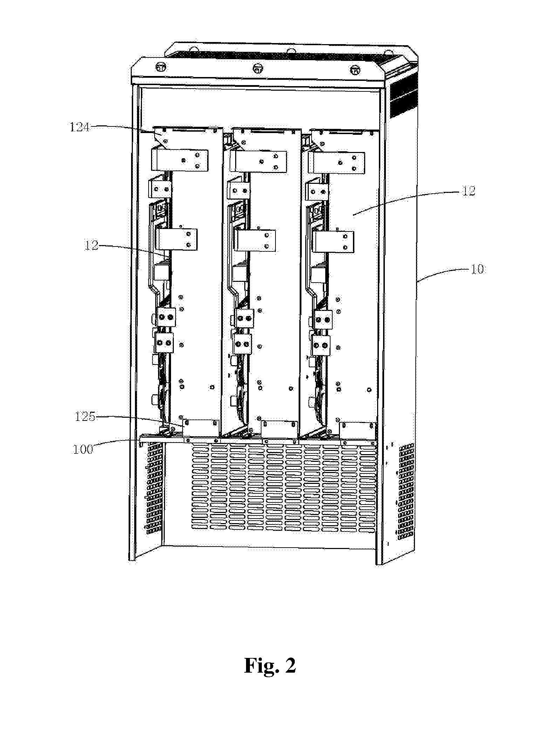

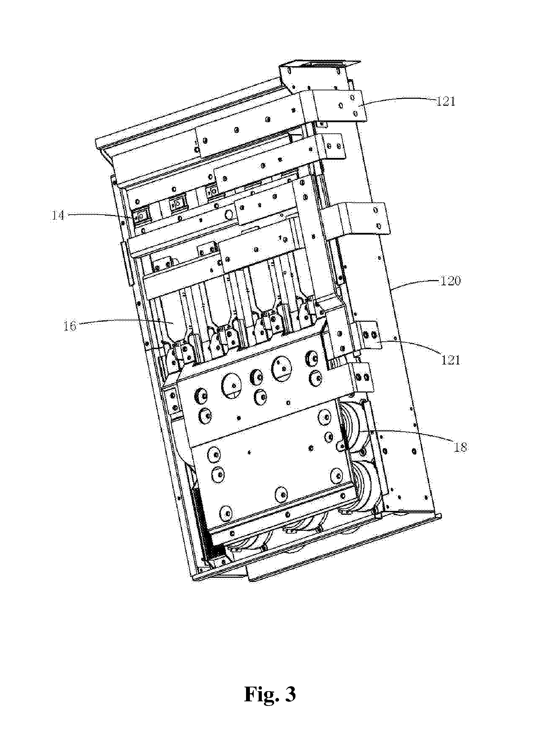

Refer to Figures 2 and 3, the frequency converter in which the main devices are modularly mounted according to the present invention includes a housing 10 and three main device units 12 which are arranged in the housing 10, wherein the housing 10 is designed to be of rectangular parallelepiped structure and a support frame 100 is provided in the housing 10 at a position close to the bottom surface of the housing 10. Three main device units 12 are supported on the support frame 100 side by side and are fixed to the housing 10 by fasteners, such as screw, so as to mount the main device units 12 in the housing 10.

The main device unit 12 includes a mounting frame 120, on which the main devices such as a rectifier bridge 14, an inverter module 16 and a plurality of capacitors 18 are fixed, as shown in Figure 3. The rectifier bridge 14, the inverter module 16 and the capacitors 18 are arranged at the upper portion, the middle portion and the lower portion of the mounting frame 120, respectively, and the connecting terminal 121 of these devices which is required to be electrically connected with the external device is arranged at the front side of the mounting frame 120, so as to facilitate the electrical connection between the main device unit 12 and the external device. Preferably, the capacitors 18 which are needed in the frequency converter are assigned into each of the main device units 12 equally, i.e. each of the main device units 12 has the same number of the capacitors 18.

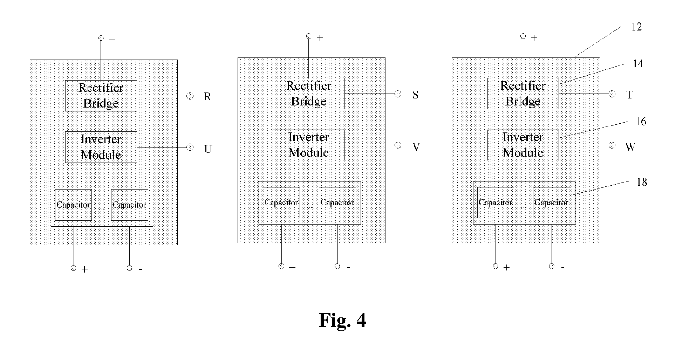

Figure 4 shows the arrangement of the main devices of the frequency converter. In such embodiment, a rectifier bridge 14, an inverter module 16 and several capacitors 18, which belong to the same phase, of the frequency converter are mounted in each of main device units 12, and the connections between all of the main devices adopt the connecting manner disclosed in the prior art. Since the main devices are divided into and form three main device units 12, connecting terminal 121 is led out from the main devices of each of main device units 12, so as to be connected with the main devices in other main device units 12. After the rectifier bridge 14, the inverter module 16 and the capacitors 18 in the same main device unit 12 are connected with each other, a connecting terminal which is used to connect with R/S/T phase input line and a positive connecting terminal which is used to connect with the rectifier bridges 14 in other main device units 12 are led out from the rectifier bridge 14; a connecting terminal which is used to connect with U/V/W phase output line is led out from the inverter module 16; while a positive connecting terminal and a negative connecting terminal are led out from the capacitor bank which are formed by the plurality of capacitors 18 connected in series or in parallel, so as to be connected with the capacitor banks of other main device units 12. Alternatively, the main devices belonging to the same phase could be arranged on different main device units 12, and it's obvious that the numbers of the connecting terminals which are required to be led out from each of the main device units 12 and used to connect with the external device are varied.

Generally, at least one radiator (not shown) is provided on the main device unit 12, so as to radiate the heat generated from the main device in operation.

As such, the rectifier bridges 14, the inverter modules 16 and the capacitors 18 of the frequency converter are separately arranged on three mounting frame 120 to form three main device units 12, such that the ratio of the length to the width of each of the main device units 12 is relative coordinate, and therefore the main device units 12 are able to cooperate and be arranged with other auxiliary devices inside the housing 10 compactly. Therefore, the space utilization rate inside the housing 10 is improved, the total volume of the frequency converter is reduced and the space cost is effectively cut down. Each of the main device units 12 includes a rectifier bridge 14, an inverter module 16 and several capacitors 18, and each of the main device units is an interchangeable modular unit. Therefore, by adopting modular mounting method, the complexity of the mounting process is reduced and the working efficiency of mounting is enhanced.

Preferably, a pair of lower guide rails 122 is formed at both sides of the lower end of the mounting frame 120, while a pair of lower guide grooves 101 is formed on the supporting frame 100 at the positions which correspond to that of the lower guide rails 122 so as to match with the lower guide rails 122. When mounting the main device unit 12, the lower guide rails 122 are positioned into the lower guide grooves 101, and then the main device unit 12 is pushed into housing 10 along the lower guide grooves 101 and fixed by the fastener. Furthermore, a pair of upper guide rails 123 is formed at both sides of the upper end of the mounting frame 120, and a pair of upper guide grooves 102 is formed inside the housing 10 at the positions which correspond to that of the upper guide rails 123 so as to match with the guide rails 123. By the cooperation between the upper guide rails 123 and the upper guide grooves 102, the main device unit 12 is guided for mounting.

Refer to Figure 2, an upper fixing plate 124 on which a hole is formed is provided at the upper end of the front side of the mounting frame 120, while a lower fixing plate 125 on which a hole is formed is provided at the lower end of the front side of the mounting frame 120. After the main device unit 12 is placed into the housing 10, screws are fastened onto the housing 10 through the upper fixing plate 124 and the lower fixing plate 125 so as to fix the main device unit 12.

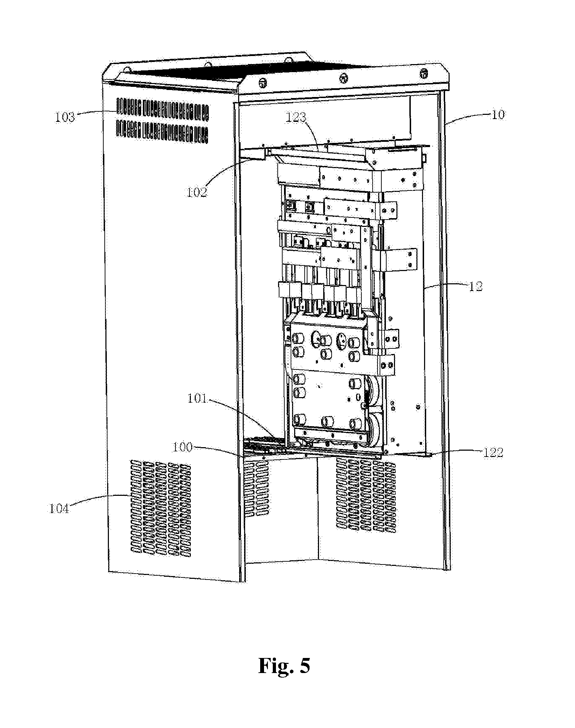

Refer to Figure 5, a cooling fan (not shown) which is used to ventilate the housing 10 is provided at the upper portion inside the housing 10. The heat generated from the main device units 12 in operation are discharged out of the housing 10 by the cooling fan in a convection manner to achieve a radiating effect and cooling effect. Of course, such cooling fan could also be arranged at the lower portion inside the housing 10. The cooling fan could be a suction fan or a blowing fan.

In general, an upper vent 103 is formed at the upper portion of the side wall of the housing 10, while a lower vent 104 is formed at the lower portion thereof. One of the upper and lower vents 103 and 104 constitutes the air inlet of the housing 10, while another one constitutes the air outlet of the housing 10, so as to form a heat dispersion passage inside the housing 10.

The above description is only the preferable embodiments according to the present invention, which does not intend to limit the present invention in any form. Equivalent modifications and improvements may be made on the basis of the above-mentioned embodiments by those skilled in the art. All the equivalent variations or modifications without departing from the sprit of the present invention are deemed to fall into the protection scope of the present invention.

## Claims

1. A frequency converter in which main devices are modularly mounted, **characterized by** comprising:
a housing (10), in which a support frame (100) is arranged;
three main device units (12), which are supported on the support frame (100) side by side,
wherein each of the main device units (12) comprises a mounting frame (120), a rectifier bridge (14), an inverter module (16), and a plurality of capacitors (18), the rectifier bridge (14), the inverter module (16), and the plurality of capacitors (18) are arranged on the mounting frame (120).

2. The frequency converter in which the main devices are modularly mounted according to claim 1, **characterized in that**, the rectifier bridge (14), the inverter module (16) and the capacitors (18), which belong to the same phase, of the frequency converter are provided in each of the main device units (12).

3. The frequency converter in which the main devices are modularly mounted according to claim 1 or 2, **characterized in that**, a connecting terminal (121) of the main device unit (12) which is used to electrically connect with an external device is provided at s front side of the mounting frame (120) .

4. The frequency converter in which the main devices are modularly mounted according to any one of the preceding claims, **characterized in that** the same number of the capacitors (18) are provided on each of the main device units (12).

5. The frequency converter in which the main devices are modularly mounted according to any one of the preceding claims **characterized in that**, a pair of lower guide rails (122) is formed at both sides of a lower end of the mounting frame (120), a pair of lower guide grooves (101) is formed on the support frame (100) at positions which correspond to that of the lower guide rails (122) so as to match with the lower guide rails (122), and the lower guide rails (122) are positioned into the lower guide grooves (101).

6. The frequency converter in which the main devices are modularly mounted according to any one of the preceding claims **characterized in that**, a pair of upper guide rails (123) is formed at both sides of an upper end of the mounting frame (120), a pair of upper guide grooves (102) is formed inside the housing (10) at positions which correspond to that of the upper guide rails (123) so as to match with the upper guide rails (123), and the upper guide rails (123) are positioned into the upper guide grooves (102).

7. The frequency converter in which the main devices are modularly mounted according to any one of the preceding claims **characterized in that**, the rectifier bridge (14), the inverter module (16) and the capacitors (18) are arranged at an upper portion, a middle portion and a lower portion of the mounting frame (120), respectively.

8. The frequency converter in which the main devices are modularly mounted according to any one of the preceding claims **characterized in that**, an upper fixing plate (124) on which a hole is formed is provided at an upper end of a front side of the mounting frame (120).

9. The frequency converter in which the main devices are modularly mounted according to any one of the preceding claims **characterized in that**, a lower fixing plate (125) on which a hole is formed is provided at a lower end of a front side of the mounting frame (120).

10. The frequency converter in which the main devices are modularly mounted according to any one of the preceding claims, **characterized in that**, the housing (10) is of a rectangular parallelepiped structure and at least one cooling fan is provided therein; an upper vent (103) is provided at an upper portion of a side wall of the housing (10), and a lower vent (104) is provided at a lower portion of the side wall of the housing (10).
